Europäisches Patentamt

**European Patent Office**

Office européen des brevets

(19)

(11) Veröffentlichungsnummer: **0 233 648 B1**

(12) # EUROPÄISCHE PATENTSCHRIFT

(45) Veröffentlichungstag der Patentschrift: **03.07.91**

(51) Int. Cl.⁵: **B25J 15/00, //H05K13/04**

(21) Anmeldenummer: **87102384.2**

(22) Anmeldetag: **19.02.87**

Die Akte enthält technische Angaben, die nach dem Eingang der Anmeldung eingereicht wurden und die nicht in dieser Patentschrift enthalten sind.

(54) **Vorrichtung zur Kupplung eines Monatagewerkzeuges, wie Greifer oder dergleichen.**

(30) Priorität: **21.02.86 DE 3605590**
**10.02.87 DE 3703993**

(43) Veröffentlichungstag der Anmeldung:
**26.08.87 Patentblatt 87/35**

(45) Bekanntmachung des Hinweises auf die Patenterteilung:
**03.07.91 Patentblatt 91/27**

(84) Benannte Vertragsstaaten:
**AT BE CH DE ES FR GB IT LI LU NL SE**

(56) Entgegenhaltungen:
**EP-A- 0 094 338**  **EP-A- 0 140 036**
**EP-A- 0 156 194**  **CH-A- 655 039**
**US-A- 4 197 638**  **US-A- 4 520 550**

(73) Patentinhaber: **SUD FINANZ S.A.**
**1 rue Philippe II**
**Luxembourg-Ville(LU)**

(72) Erfinder: **Goldbecher, Heinz, Dr.**
**Wustbach 7**
**W-5632 Wermelskirchen 1(DE)**

(74) Vertreter: **Rieder, Hans-Joachim, Dr.**
**Corneliusstrasse 45 Postfach 11 04 51**
**W-5600 Wuppertal 11(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

**Beschreibung**

Die Erfindung bezieht sich auf eine Vorrichtung zur Kupplung eines Montagewerkzeuges, wie Greifer oder dergleichen, gemäß Oberbegriff des Patentanspruchs 1.

Eine Vorrichtung dieser Art ist durch die EP-A-094 338 bekannt. Diese Vorrichtung weist einen mit dem Roboterarmende steckverbundenen Revolverkopf-Träger auf mit spitzwinklig zur Steckverbindungsachse liegender, mit einem Einstellmotor gekuppelter Revolverkopf-Drehachse und einer Revolverkopf-Verriegelungseinrichtung derart, daß jeweils eine von mehreren Montagewerkzeug-Aufnahmen in koaxialer Stellung zur Steckverbindungsachse liegt, wobei sich die Verlängerung der Steckverbindung, die Verlängerung der Revolverkopf-Drehachse und die sämtlicher Montagewerkzeug-Aufnahmenachsen in einem Punkt schneiden. Revolverkopf-Drehachse und Steckverbindungsachse stehen in einem Winkel von 45° zueinander.

Aufgabe der Erfindung ist es, eine solche Vorrichtung mit zentral orientiertem Aufbau hinsichtlich der Zuordnung der die Greifer steuernden Organe raum- und steuerungsoptimal zuzuordnen.

Gelöst ist diese Aufgabe durch die im Anspruch 1 angegebene Erfindung.

Die Unteransprüche sind vorteilhafte Weiterbildungen der erfindungsgemäßen Vorrichtung.

Der Greifer- oder Werkzeugantrieb erfolgt durch mindestens zwei im Revolverkopf-Drehteller vorgesehene, spitzwinklig und symmetrisch zur Einstecköffnungsachse sowie revolverkopfseitig konvergierend liegende, druckmittelbetätigbare Stöße, deren drehfugenseitige Aufnahmeöffnungen in jeder Drehstellung des Revolverkopfes koaxial fluchtend liegen zu einem Einfahrraum des Revolverkopfes, welcher Einfahrraum in Verbindung steht mit den als Einsteckhöhlungen ausgebildeten Montagewerkzeug-Aufnahmen. Weiter wird vorgeschlagen, daß der Schnittpunkt der konvergierenden Stößel auf der Verlängerung der Steckverbindungsachse liegt, welche als Einstecköffnungsachse zu bezeichnen ist, da das Ende des Roboterarmes dort in eine Einstecköffnung des Revolverkopfes eingesetzt ist. Die symmetrisch zu wählende Konvergenz bringt gleichberechtigte Antriebs- bzw. Betätigungsverhältnisse für alle in diesem Schnittpunkt gesteuerten Montagewerkzeuge, da die Revolverkopf-Drehachse den Einfahrraum zentral kreuzt. Der Schnittpunkt liegt unterhalb der Revolverkopf-Drehachse. Die gedachte Flächenebene der Stößelachsen schneidet also die Drehachse. Zusammenfassend ist daher festzuhalten, daß eine solche Vorrichtung als Roboter-Multifunktionalhand räumlich optmial aufgeteilt und vor allem auch von sehr gedrungener Bauart ist. Das programmgesteuerte Werkzeug, wie beispielsweise der Greifer, fährt infolge des rotationssymmetrischen Aufbaues des Revolverkopfes nur in Bruchteilen von Sekunden an Leerzeit in die zugedachte Position, wobei zufolge der Koaxialität von Roboterarm-Einstecköffnungsachse und der Montagewerkzeug-Aufnahme ein linearer Kraftweg vorliegt. Das Arbeitsmedium, beispielsweise Druckluft, wird über eine zentrale Druckmittelzufuhr im Bereich der Einstecköffnung zugebracht. Überdies erweist es sich als vorteilhaft, daß im Bereich der Drehfuge zwischen Revolverkopf-Träger und Revolverkopf eine die Revolverkopf-Stellung abfragende Kodierscheibe angeordnet ist. Das ganze wirkt mit einem Programm-Computer zusammen. Konkret ist die Revolverkopf-Verriegelungseinrichtung von einem druckmittelgesteuerten Riegelbolzen gebildet, welcher im Revolverkopf-Träger sitzend, über die Drehfuge tretend, in die Kodierscheibe eintritt. Letztere weist entsprechende Eingriffvertiefungen auf. Das Ablesen der Kodierscheibe geschieht mittels Näherungsinniatoren, welche mit Eisenkernen zusammenwirken und die angesteuerte Stellung in Form einer Rückmeldung an eine Überwachungsstelle leiten. Das und vor allem die minimalen Steuerzeiten können bei Auftreffen auf ein Hindernis zu teuren Beschädigungen führen. Es ist daher zweckmäßig, die Multifunktionshand des Roboters sensibler zu gestalten, d. h. die Vorrichtung so weiter zu bilden, daß deren Einsatz sicherheiterhöht ist und daß sie bei Störungen, wie insbesondere unprogrammgemäßen Belastungen, sofort reagiert. Hierzu wird vorgeschlagen, daß der Revolverkopf in Richtung der Einsteck-Öffnungsachse unter Bildung eines Freiganges längsverschieblich im Roboterarm geführt ist. Zufolge solcher Ausgestaltung ist der Gebrauchs- und Sicherheitswert erhöht: Der in der direkten Kraftrichtung liegende Freigang erlaubt bei greiferseitigem, vom Programm abweichenden Anstoß ein Ausweichen. Dieses geschieht praktisch bremsend. Das hochempfindliche Werkzeug wird daher geschont. Die Relativbewegung von Revolverkopf und Roboterarm läßt sich weiter sichernd in der Weise nutzen, daß der zweckmäßig zwischen Revolverkopf-Träger und dem Roboterarm verwirklichte Verschiebe-Freigang elektrisch abgefragt wird. Der hieraus resultierende Impuls wird über eine Steuerunganlage zum dortigen Abschalten der Vorrichtung verwendet, und zwar im Sinne von (Aus, Ein und so auch für einen erneuten Versuch). Diese einen Grob-Crash vermeidende Ausgestaltung umfaßt in baulicher Hinsicht weiter eine Maßnahme dahingehend, daß die Längsführung von einer revolverkopf-trägerseitigen Büchse und einem darin koaxial geführten Schaft gebildet ist. Um hier zugleich eine bei Grobeinwirkungen überlaufbare Drehsicherung zu realisieren, bringt die Erfindung weiter in Vorschlag, daß der Schaft an seiner äußeren Mantelfläche mehrere Längnuten trägt, welche mit radial nach innen vorgespannten Rollgliedern der Büchse zusammenwirken. Stößt der Revolverkopf daher im Sinne eines erhöhten Drehmoments an, weichen die Rollglieder federnd aus; die definierte Lage läßt sich nach Entfernen des Hindernisses sofort wieder exakt einstellen. Verlaufen die Längsnuten in gleicher Winkelverteilung, besteht hieraus die Möglichkeit, dem Revolverkopf-Träger verschiedene Winkel-Grundstellung zu geben. Eine vorteilhaft Weiterbildung besteht dabei in einer Gewichtskompensations-Vorrichtung für den Revolverkopf sowie dessen Träger, welche Vorrichtung von einer Kolben-Zylinder-Einheit gebildet ist. Bei einem Kopfgewicht beispielsweise von 1,5 kg kann mittels eines pneumatischen, konstanten Gegendrucks beispielsweise dafür gesorgt werden, daß nur noch eine Gegenlast von 0,5 kg überwunden werden muß. Der Revolverkopf wird dadurch auch sensibler. Im einzelnen ist die Gewichtskompensations-Vorrichtung dahingehend ausgebildet, daß der Kolben der Kolben/Zylinder-Einheit mittels einer in Einsteck-Öffnungsachsen-Richtung verlaufenden Kolbenstange am Roboterarm befestigt und daß der Zylinder am Revolverkopf-Träger ausgebildet ist. Zum Einbringen des pneumatischen Druckpolsters erweist es sich als vorteilhaft, daß zur Zuleitung des Druckmittels für die Kolben/Zylinder-Einheit die Kolbenstange mit dem Axialkanal durchsetzt ist. Entsprechend günstig läßt sich dabei die Speisung über einen Versorgungskanal des Armes realisieren und variieren. Bezüglich der Abfragung der Relativbewegung zwischen Revolverkopf-Träger und Roboterarm wird zweckmäßig so vorgegangen, daß der Freigang-Hub von einer Erfassungseinrichtung registriert und einer Steuervorrichtung des Roboterarmes zugeführt wird. Dabei ist günstig, daß die Erfassungseinrichtung als induktive oder kapazitive Wegabfragung ausgebildet und von einem im Wege des Kolbens liegenden Initiator gebildet ist. In bestimmten Fällen eigenen sich auch bereits die klassischen Mikroschalter. Der Greifer- oder Werkzeugantrieb erfolgt, wie schon weiter oben ausgeführte, durch die zwei im Revolverkopf-Träger vorgesehenen, spitzwinkligen und symmetrisch zur Einstecköffnungsachse sowie revolverkopfseitig konvergierend verlaufenden, druckmittelbetätigbaren Stößel. Der eine Stößel steuert beispielsweise einen Greifer; der andere, auch als Pusher bezeichnete Stößel, betätigt beispielsweise einen Drücker bzw. eine Druckfinger. Im Ausführungsbeispiel wird näher auf die Aufgaben dieser Teile eingegangen werden. Vorteilhaft ist es weiter, daß mindestens einer der Stößel mit einer Stößelstellungs-Erkennungseinrichtung versehen ist. Letztere ist unter Verwendung einer Induktionsspule gebildet, in der ein mit dem Stößel verbundener Kern längsverschieblich einliegt. Solche Einrichtungen wirken hochempfindlich. Die Kennung liegt im Bereich von zentel Millimeter. Die Abstimmung zur Erzielung eines Signals kann so erfolgen, daß bei nicht vollständigem Durchlaufen des laut Programm jeweils vorgesehenen Gesamthubs die Bestückungsfunktion gestoppt wird bzw. ein neuer Versuch erfolgt. Endlich ist noch eine vorteilhafte Ausgestaltung erzielt durch eine Rutschkupplung vor der Stirnfläche des Revolverkopfes. Auch das vermeidet überhöhte Beanspruchungen.

Weitere Einzelheiten des Gegenstandes der Erfindung sind nachstehend anhand eines zeichnerisch veranschaulichten Ausführungsbeispieles näher erläutert. Es zeigt:

Fig. 1     den Revolverkopf in weitestgehend schematisierter Wiedergabe, am Ende eines Roboterarmes sitzend,

Fig. 2     den Schnitt gemäß Linie II-II in Fig. 1,

Fig. 3     den Schnitt gemäß Linie III-III in Fig. 2,

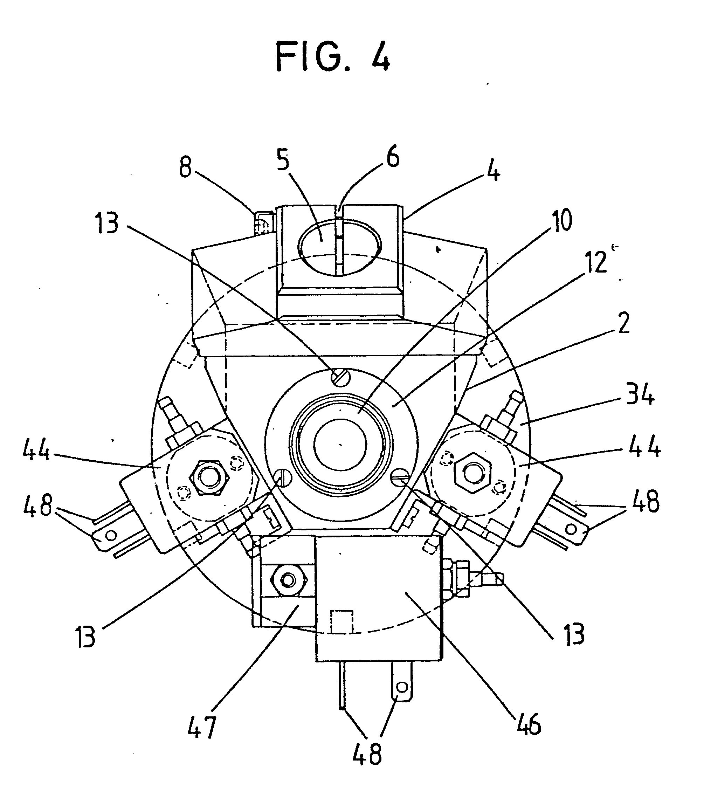

Fig. 4     die Ansicht in Pfeilrichtung A in Fig. 2.

Fig. 5     die erfindungsgemäße Vorrichtung in teilweise aufgebrochener Wiedergabe, am Ende eines Roboterarmes sitzend,

Fig. 6     den Schnitt gemäß Linie VI-VI in Fig. 1,

Fig. 7     die Bewegungsstudie eines Bestückungsvorganges unter normalem Ablauf sowie in strichpunktierter Linienart wiedergegebenem Störanlaß, bei dem der Grobsensor im Freigangbereich anspricht und

Fig. 8     einen Störfall bei der Bestückung, in welchem Falle der Störgrund induktiv registriert und in eine Maßnahme zur Abhilfe umgesetzt wird.

Die am Armende 1 eines mehrere Gelenke aufweisenden Roboterarmes sitzende Vorrichtung besitzt einen Revolverkopf-Träger 2 mit darauf drehbar gelagertem Revolverkopf 3.

Zur Befestigung des besagten Endes 1 weist der Revolverkopf-Träger 2 im Bereich eines ihm angeformten Stutzens 4 eine zylindrische Einstecköffnung 5 auf. Zufolge eines auf einer Teillänge des Sutzens berücksichtigten Längsschlitzes 6 ist eine Art Schelle realisiert. Im Längsschlitzbereich wurzeln parallel verlaufende, im wesentlichen radial nach auswärts gerichtete Backen 7, die mittels einer sie quer durchsetzenden Schraube 8 unter Reduzierung der Öffnungsweite gegeneinander verspannbar sind. Die Einsteköffnung ist als Sackbohrung realisiert.

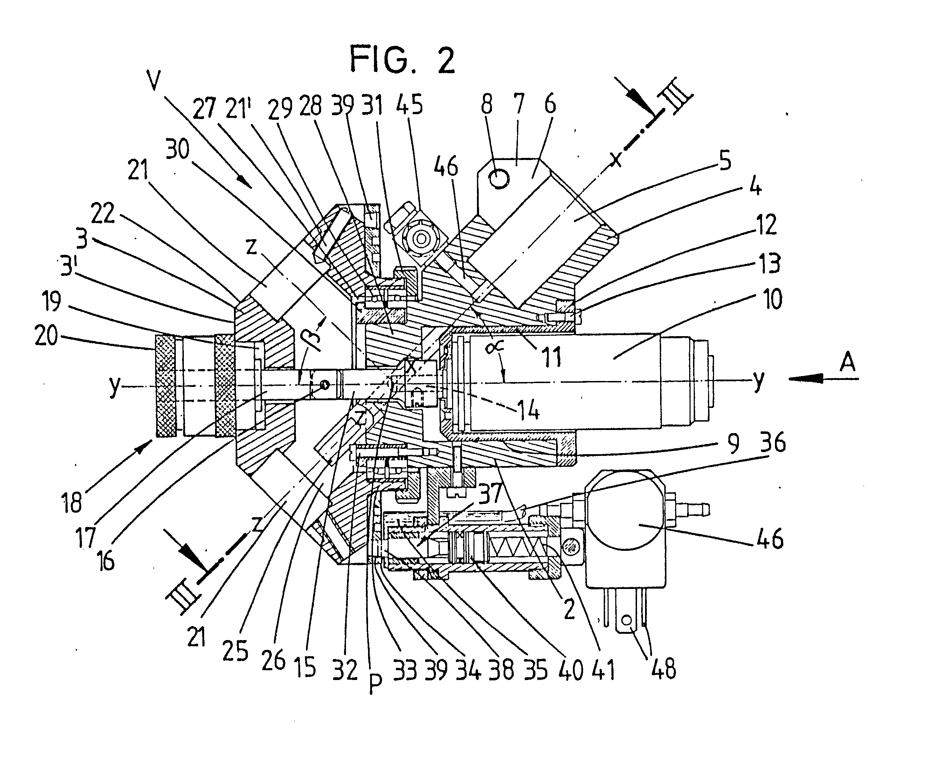

Der Revolverkopf-Träger 2 ist überdies zentral gehöhlt bzw. durchbrochen. Die entsprechende zylindrische Ausdrehung 9 nimmt einen Einstellmotor 10 auf. Es kann sich hier um einen Elektrogetriebemotor handeln. Letzterer steckt gemäß Fig. 2 in einer Büchse 11, welche, nicht ganz bis zum Boden der Ausdrehung 9 reichend, am entgegengesetzten Ende einen Ringflansch 12 ausbildet. Diesen durchsetzende Halteschrauben 13 legen die Büchse 11 am Revolverkopf-Träger 2 fest.

Die in Richtung des Revolverkopfes 3 weisende Abtriebswelle 14 des Einstellmotors 10 durchsetzt eine zentrale Öffnung im Boden der topfförmigen Büchse 11. Die Abtriebswelle 14 ist lösbar mit einer Zwischenwelle 15 verbunden. Letztere steht über ein Gelenk 16 mit der koaxial anschließenden Welle 17 einer Rutschkupplung 18 in Verbindung. Die Rutschkupplung 18 erstreckt sich vor der planen Stirnfläche 3' des Revolverkopfes 3 und ragt mit einem Endabschnitt in eine konzentrische Ausnehmung 19 des Revolverkopfes 3. Die Rutschkupplung 18 ist mittels der Handhabe 20 auf die gewünschte Bremswirkung einstellbar.

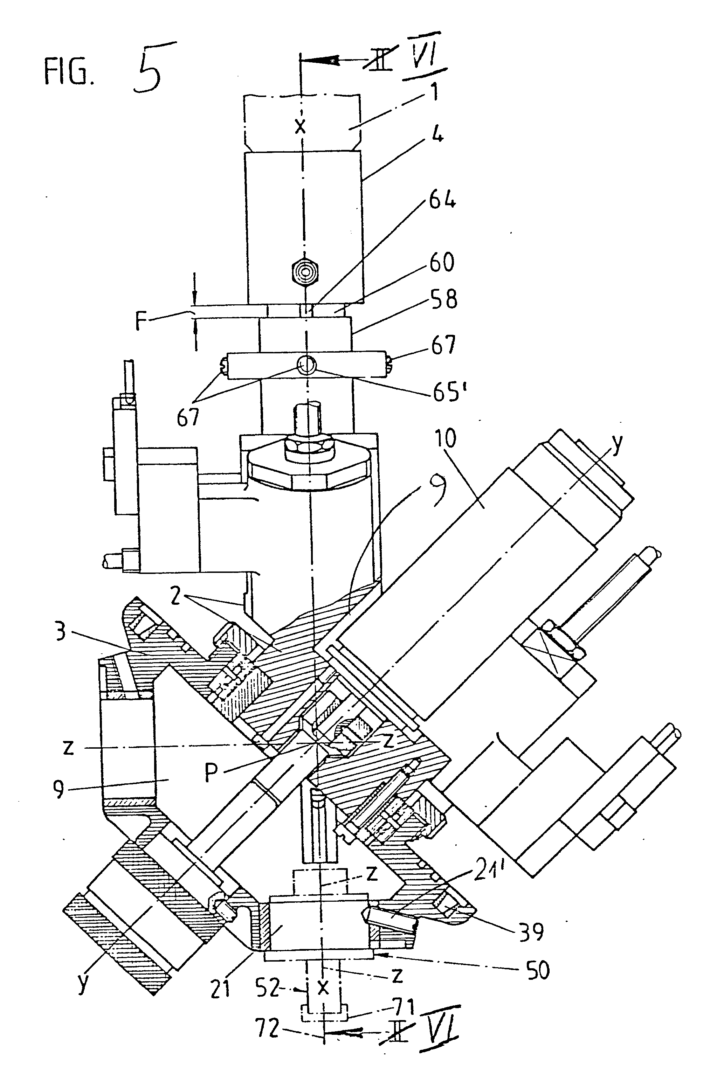

Sinn und Zweck des Einstellmotors 10, welcher gemäß Fig. 5 in einer nicht ausgefütterten Ausdrehung verschraubt ist, ist es, den eine Anzahl von Aufnahmen 21 für nicht dargestellte Montagewerkzeuge etc. aufweisenden Revolverkopf 3 in die jeweilige Arbeitsposition zu drehen. Die jeweilige betriebsgerechte Arbeitsstellung ist sodann anschlagedefiniert.

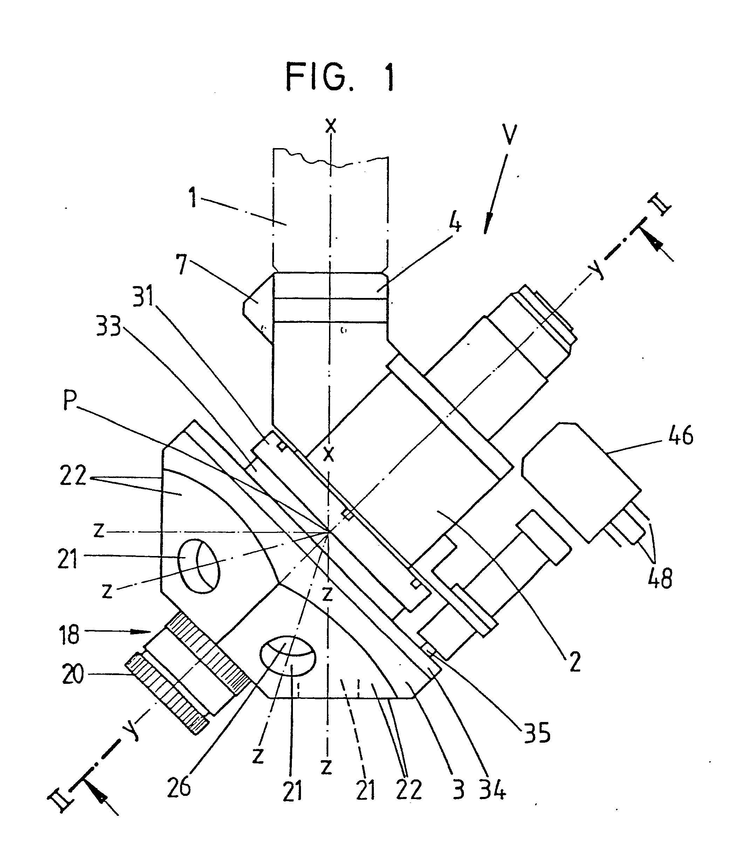

Um bei möglichst hoher Anzahl an Montagewerkzeug-Aufnahmen 21 trotzdem eine räumlich günstige Arbeitposition zu erhalten, erstreckt sich die Einstecköffnungsachse x-x im spitzen Winkel Alpha von 45° zur Revolverkopf-Drehachse y-y (Fig. 1).

Die Montagewerkzeug-Aufnahmen 21 liegen, rotationsmäßig betrachtet, in gleichem Winkelabstand zueinander. Es sind insgesamt sechs solcher Aufnahmen 21 am Revolverkopf 3 realisiert. Letztere gehen von Facettenflächen 22 entsprechender Anzahl des Revolverkopfes 3 aus. Deutlich wird die besagte Facettierung aus Fig. 1.

Wie Fig. 2 entnehmbar, erstrecken sich die trägerseitigen Verlängerungen der Montagewerkzeug-Aufnahmenachsen z-z ebenfalls spitzwinklig zur Revolverkopf-Drehachse y-y. Auch hier liegt ein Winkel beta von 45° zugrunde. Insgesamt ergibt sich so eine Achsenkonstellation dahingehend, daß sich die Verlängerung der Einstecköffnungsachse x-x, die Verlängerung der Revolverkopf-Drehachse y-y und die Verlängerungen der Montagewerkzeug-Aufnahmeachsen z-z sämtlich in einem gemeinsamen Punkt P schneiden. Dieser Punkt liegt praktisch im Zentrum des Roboterkopfes 3.

Hieraus ergibt sich, daß jeweils eine der sechs Montagewerkzeug-Aufnahmen 21 in koaxialer Stellung zur Einstecköffnungsachse x-x, d. h. deren Verlängerung, liegt.

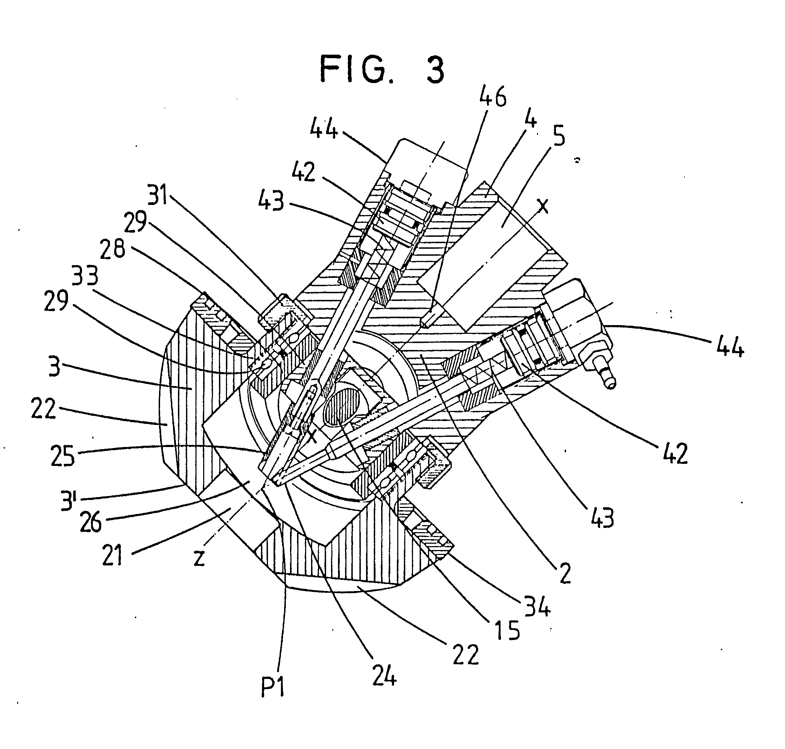

Bestimmt ist die betriebsgerechte Arbeitsposition durch das Montagewerkzeug oder dergleichen betätigende Stößel 24, 25. Letztere sind druckmittelbetätigt. Sie durchsetzen den Revolverkopf-Träger 2 und nehmen einen spitzwinkligen, in Richtung des Revolverkopfes 3 konvergierenden Verlauf. Im Winkelinnenraum liegt der die Einstellöffnung 5 formende Abschnitt des Trägers 2. In Scheitelnähe kreuzen Abtriebs- und Zwischenwelle 14, 15. Die auch hier gewählte spitzwinklige Lage zur Einstecköffnungsachse x-x ergibt sich aus Fig. 3. Die Winkelebene bzw. Neigungslage fällt dagegen mit dem Winkel Alpha zusammen. Ebenenmäßig den Punkt P schneidend, liegt der Schnittpunkt P1 der konvergierenden Stößel 24, 25 auf der Verlängerung der Einstecköffnungsachse x-x, aber räumlich deutlich unterhalb der in Fig. 2 horizontal verlaufenden Revolverkopf-Drehachse y-y.

In diesen Bereich des Schnittpunktes P1 reicht auch der Rücken von in den Fig. 5 bis 8 näher dargestellten Montagewerkzeugen 50. Unter Berücksichtigung der Lager der frei aus dem Revolverkopf-Träger 2 vorstehenden Köpfe der in je in den Bereich einer Aufnahmeöffnung des Trägers 2 geführten Stößel 24, 25 ist das Zentrum des Revolverkopfes 3 relativ großräumig ausgedreht, so daß ein die Drehbewegung des Revolverkopfes 3 nicht störender Einfahrraum 26 vorliegt. Der Einfahrraum 26 steht mit den als zylindrische Einsteckhöhlungen für die Montagewerkzeuge ausgebildeten Aufnahmen 21 in Verbindung. Zur Festlegung des darin eingesteckten Montagewerkzeug-Fußes dienen radial ausgerichtete Madenschrauben 21'.

Rückwärtig des Einfahrraumes 26 erstreckt sich eine zentrale, zylindrische Lagerhöhlung 27 (vergl. Fig. 2). In letztere ragt vom freien Ende her ein ebenfalls zylindrischer Stutzen 28 des Revolverkopf-Trägers 2. Dazwischen liegen, paarig angeordnet, Kugellagerringe 29, welche beiderends von Halteringen 30, 31 lagesichernd übergriffen sind. Der vom revolverkopfseitigen Ende her zugeordnete Haltering 30 erhält seine Fixierung über in den Revolverkopf-Träger 2 eingedrehte Halteschrauben 32. Der andere, externe Haltering 31 ist als Schraubring realisiert. Er findet sein Gegengewinde auf einem die Kugellagerringe 29 peripher axial übergreifenden Kragen 33 des Revolverkopfes 3.

Auf den Kragen 33 ist eine Kodierscheibe 34 aufgesteckt und durch nicht näher dargestellte Mittel befestigt. Die Kodierscheibe 34 reicht bis zum Umfangsrand des Revolverkopfes 3. Sie erstreckt sich im Bereich der Drehfuge zwischen Revolverkopf-Träger 2 und dem Revolverkopf 3. Die Kodierscheibe tastet die jeweilige Drehposition des Revolverkopfes ab. Sie wirkt dazu mit einem Näherungsinitiator 35 zusammen, welcher über eine Leitung 36 mit der zentralen Steuerstelle verbunden ist.

Die Kodierscheibe 34 wirkt überdies mit einer Revolverkopf-Verriegelungseinrichtung 37 zusammen. Bestandteil derselben ist ein Riegelbolzen 38. Dieser sitzt federbelastet in einer Riegelausnehmung 39. Jeder der sechs auf einem mehrseitigen Pyramidenstumpf verteilt angeordneten Aufnahmen 21 ist eine solche Riegelausnehmung 39 zugeordnet. Der stößelartige Riegelbolzen 39 setzt sich auf der dem Revolverkopf 3 abgewandten Seite in einen Steuerkolben 40 fort. Im Anschluß daran befindet sich auf dessen freiem Kolbenschaft eine Schraubengang-Druckfeder 41, die am freien Ende ihre trägerseitige Abstützung findet. Durch Einbringen eines das revolverkopfseitige Ende des Steuerkolbens 40 beaufschlagenden Druckmittels wird die Entriegelung bewirkt und anschließend über den Einstellmotor 10 das nächste Werkzeug in die ausgewählte, betriebsbereite Stellung gefahren, d. h. in die koaxiale Stellung zur Einstecköffnungsachse x-x.

Die Steuerung der beiden Stößel 24, 25 geschieht ebenfalls druckmittelveranlaßt. Die Stößel bilden dazu an den nach auswärts führenden, dem Revolverkopf 3 abgewandten Schaftenden je einen Steuerkolben 42 aus, welche in einer Zylinderbohrung des Revolverkopf-Trägers 2 laufen. Dort geschieht die Beaufschlagung durch das Druckmittel von der dem Revolverkopf 3 abgewandten Seite her, während eine Schraubengang-Druckfeder 43 die Rückführung in die zurückgezogene Grundstellung bewirkt. Hinter den Kolben 42 sitzen Druckluftanschlüsse 4, die, über einen nicht näher dargestellten Ringanschluß gesteuert, gespeist werden. Die Druckmittelzufuhr geschieht zentral, und zwar im Bereich der Einstecköffnung 5. Hier nimmt die vom Boden dieser Einstecköffnung 5 ausgehende, zu einem Hauptanschluß 45 führende Leitung 46 ihren Anfang. Der Arm selbst enthält intern die hier nicht näher dargestellte Versorgungsleitung. Das der Revolverkopf-Verriegelungseinrichtung 37 zugedachte Anschlußstück ist mit 46 bezeichnet und sitzt an einer dieses mit dem Träger 2 verbindenden Konsole 47. Sämtliche Druckluftventile besitzen Stecker 48 für Steuerungs-Elektrozuleitungen.

Vor den revolverkopfseitigen Stößelenden liegen in erreichbarer Nähe das Betätigungsende 51 eines Greifers 52 sowie das freie Ende 53 eines Druckfinger 54 des Montagewerkzeuges 50.

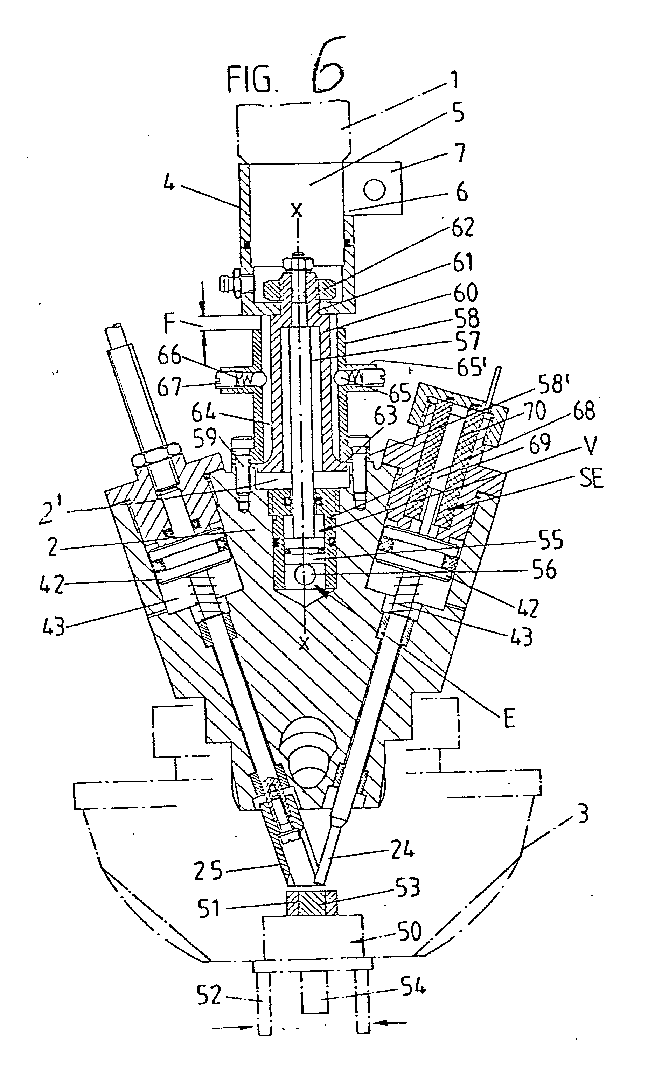

Die Backen des Greifers 52 werden durch die Kraft einer im Werkzeug 50 untergebrachten Feder offengehalten. Ebenso belastet eine nicht dargestellte Feder den Druckfinger 54 in Richtung seiner Grundstellung (Fig. 6).

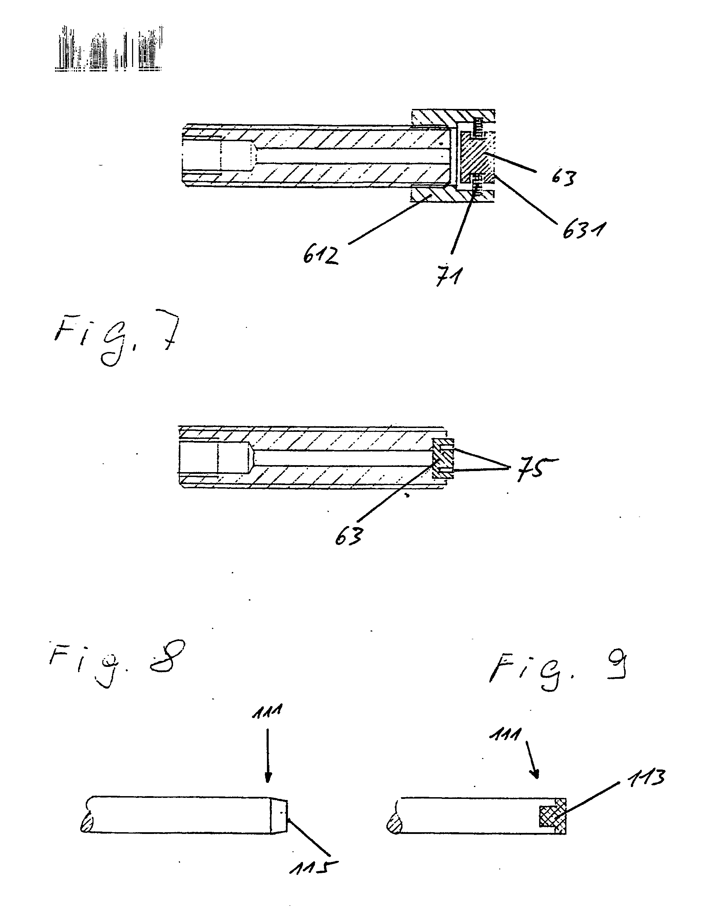

Die Vorrichtung ist mit einem Beschädigungsschutz ausgestattet, der das sofortige Stillegen der Roboterhand bewirkt, sobald der Revolverkopf 3 einen größeren Widerstand wahrnimmt. Um dies in einer Ausweich-bzw. Relativbewegung umzusetzen, ist der Revolverkopf 3 in Richtung der Einsteck-Öffnungsachse x-x des Armendes 1 unter Bildung eines Freiganges F längsverschieblich am Roboterarm geführt, und zwar zwischen dem Revolverkopf-Träger 2 und dem Roboterarm 1. Beim nicht programmgemäßen Auftreffen des vertikal abwärtsfahrenden Montagewerkzeuges 50 auf z. B. einen Körper K (Fig. 7), weicht der Revolverkopf 3 entsprechend aus. Dies wird zur elektrischen Wegabfragung genutzt, indem der Freigang-Hub von einer Erfassungseinrichtung E registriert und einer Steuervorrichtung des Roboterarmes 1 zugeführt wird. Bezüglich der Erfassungseinrichtung kann es sich um eine solche induktiver oder kapazitiver Art handeln. Das Ausführungsbeispiel bevorzugt einem im Weg eines Kolbens 55 liegenden Initiator 56. Dieser, wie ein Tastfinger wirkende Kolben 55 setzt sich in Ausweichrichtung des Revolverkopfes 3 verlaufend in einen Kolbenschaft 57 fort, welcher fest mit der vom Stutzen 4 gebildeten Aufnahme des Armendes 1 verbunden ist. Beim Ausführungsbeispiel handelt es sich um eine Schraubverbindung. In der aus Fig. 6 ersichtlichen Arbeitsbereitschaftsstellung erstreckt sich die revolverkopfseitige Kolbenstirnflächenebene an der oberen Randkante des Sensors (Initiator 56). Mit zunehmendem Ausweichen verlagert sich die Sensorfläche in den Mantelwandbereich des genannten Kolbens 55.

Die Verschiebe-Führung übernimmt eine Büchse 58. Letztere ist im Rücken des Trägers 2 an diesem befestigt. Sie weist dazu trägerseitig einen Ringflansch 58' auf für Befestigungsschrauben 59. Insoweit ist die Büchse 58 funktionaler Bestandteil des Revolverkopf-Trägers 2.

Koaxial zum Armende 1 verlaufend führt sich in der Büchse 58 ein Schaft 60. Letzterer ist mit dem die Einstecköffnung 5 formenden, topfförmigen Stutzen 4 verschraubt. Der Topfboden des Stutzens 4 weist dazu eine zentrale Durchbrechung 61 auf. Durch letztere hindurch ragt ein abgesetzter Abschnitt des Schaftes 60, dessen dortige Mantelfläche mit Gewinde versehen ist zum Angriff einer Mutter 62. Der Kolbenschaft 57 überragt den abgesetzten Abschnitt des Schaftes 60 noch und weist ebenfalls ein Gewinde auf, welches zur Aufnahme einer Befestigungsmutter dient.

Das revolverkopfseitige Ende des Schaftes 60 bildet weiter eine auswärtsgerichtete, ringförmige Tragschulter 63 aus. An dieser hängt der gesamte Revolverkopf-Träger 2, indem diese Tragschulter 63 das dortige Stirnende der Büchse 58 randhintergreift. Der Revolverkopf-Träger 2 ist dazu entsprechend radial ausgedreht und besitzt eine der Freigangangabe zwischen den freien Büchsenrand und der Unterseite des Topfes entsprechende Tiefe in axialer Richtung. Die raumbildende Ausdrehung ist mit 2' bezeichnet.

An seiner Mantelfläche weist der Schaft 60 mehrere Längsnuten 64 auf. Insgesamt sind vier solcher, winkelgleich verteilter Längsnuten realisiert. In die Längsnuten 64 greift je ein Rollglied 65 ein. Es handelt sich um Kugelkörper. Diese sind in Radialkammern 65' der Büchse 58 untergebracht. Sie stehen unter Wirkung einer Schraubengangdruckfeder 66, welche sie gegen die V-kerbenartigen Flanken der Längsnuten 64 drücken. Die Federkraft ist regulierbar zufolge rückwärtiger, das äußere Federwiderlager bildender Madenschrauben 67 mit auswärtsgerichteter Werkzeugangriffsstelle. Unter gewaltsamem Drehen des Revolverkopf-Trägers 2 auf dem Schaft 60 weichen die Rollglieder 65 aus, so daß programmgemäß nicht vorgesehene Belastungen des Trägers 2 nicht zu einer Zerstörung führen können. Zufolge gleicher Winkelabstände der Längsnuten 64 läßt sich der Revolverkopf-Träger 2 auch in mehrere Grundstellungen bringen.

Um den Revolverkopf 3 zu entlasten, so daß bei einer Verlagerung unter Verkleinerung des Freiganges F nicht das gesamte, aus Träger 2, Revolverkopf 3, Montagewerkzeug 50 usw. bestehende Gewicht angehoben werden muß - was z. B. zur Zerstörung des zu montierenden Teils führen kann, ist dem Revolverkopf-Träger eine Gewichtskompensations-Vorrichtung V einverleibt. Sie besteht aus einer Kolben/Zylindder-Einheit, wobei der bereits erläuterte Kolben 55 auch für diese Einheit verwendet wird. Der zugehörige Zylinder ist mit 68 bezeichnet. Es handelt sich um einen topfförmigen Grundkörper, der im Wege einer Schraubverbindung seine Zuordnung zum Revolverkopf-Träger 2 findet. Der Topfboden weist eine zentrale Durchbrechung zum auswärtsgerichteten zentralen Durchtritt des Kolbenschaftes 57 auf. Die Fugenbereiche sind abgedichtet. Der zwischen dem Kolbenrücken und dem Topfboden liegende Raum enthält als Druckmittel Luft. Der Druck ist exakt einstellbar bzw. verstellbar, in Anpassung an die unterschiedlich auftretenden Gewichte bei der Werkzeugbestückung des Revolverkopfes 3. Die Zuleitung des Druckmittels für die Kolben/Zylinder-Einheit 55/68 geschieht zweckmäßig unter Nutzung der Kolbenstange 57 als Rohrleitung,. indem diese zentral ausgebohrt ist und über einen Querkanal mit dem Druckraum im Verbindung steht (nicht näher dargestellt).

Neben dem erläuterten Grobsensor für die Ein/Aus-Funktion oder zur Durchführung eines erneuten Arbeitsversuches, ist noch die einer Feinabtastung berücksichtigt, und zwar in Bezug auf den als sogenannter Pusher arbeitenden Stößel 24. Letzterer übernimmt die Aufgabe der Ausschuß-Anzeige. Die entsprechende Stößelstellungs-Erkennungseinrichtung trägt das Bezugzeichen SE. Sie arbeitet auf induktivem Wege. Dazu setzt sich der Schaft in einen den Kolben 42 revolverkopfabgewandt überragenden Kern 69 fort. Dieser Eisenkern reicht in die zentrale Höhlung einer Induktionsspule 70. Der Stößel 24 ist hubmäßig je nach vorliegendem Programmschritt auf einen Maximalweg abgestimmt. Wird dieser Weg nicht voll durchfahren bzw. wird er durchfahren, jedoch bei einer vom Programm abweichenden Koordinate des Roboterarmes, so bedeutet dies, daß der Druckfinger 54 ein Hindernis vorfindet, beispielsweise auf Grund einer Fehlbestückung.

Die Funktionsweise wird nachstehend insbesondere an Hand der Figuren 7 und 8 erläutert:
Der Revolverkopf 3 hat beispielsweise entsprechend seiner Mcntagewerkzeugzahl sechs Elektronikbauteile 71 aus einem nicht näher dargestellten Magazin entnommen. Jeder Greifer 52 des Montagewerkzeuges 50 hält das entsprechende Bauteil fest und führt es bei entsprechendem Programmschritt in die Montageposition I gemäß Fig. 7. Das Elektronikbauteil 71 besitzt zwei parallelverlaufende, gleichlange Steckfüße 72, sogenannte Pins. Die Vorrichtung senkt sich abwärts in Richtung einer horizontalen Platine 73, die an kongruenter Stelle zu den Steckfüßen 72 paarig angeordnete Durchbrechungen 74 aufweist. Die Steckfüße 72 werden in einer Größenordnung von zehntel Milimetern in die Platine eingesetzt, vergl. Montageposition II. Ist diese Situation erreicht, drückt der Pusher (Stößel 24) den Druckfinger 54 druckmittel veranlaßt abwärts. Das geschieht in der Montageposition III. Die Greiferbacken können dabei schon überlagernd gespreizt werden unter Freigabe des Elektrobauteils 71, sie können aber auch noch als Führung dienen, wie hier bevorzugt. Der Druckfinger 54 bewirkt die vertikale Restverlagerung des Elektronikbauteiles 71. Ein im Rücken der Platine 73 exakt positionierter Spreizklotz 77 bewirkt über Dachschrägen des Umlegen der Steckfüße 72 im Rücken der Platine, um das Elektrobauteil 71 gegen Herausfallen zu sichern (vergleiche Position III in Fig. 7).

Wird bei diesem normalen Ablauf dagegen für die Vorrichtung ein Hindernis erkennbar, wie beispielsweise das eines bereits positionierten Körpers K (vergl. Fig. 7, Position I), so schiebt sich der Revolverkopf-Träger 2 bei einer im Programm nicht vorgesehenen Stelle relativ zum Armende ein (Freigang F), wobei der Initiator 56 sofort die Montagefunktion abbricht. Es kommt dabei nicht zu Beschädigungen der Werkzeuge bzw. des Revolverkopfes. Der Stößel 24 tritt gar nicht erst in seine Funktion.

Die entsprechende Ausschußfunktion ergibt sich aus der Bewegungsstudie gemäß Fig. 8: Dort ist beispielsweise das erfaßte Elektronikbauteil 71 nicht montagebereit, da einer der Steckfüße 72 aus seiner Parallelität getreten ist. Diese Situation liegt in der Position IV vor. Fährt nun der Revolverkopf 3 abwärts, kommt es zu der zu Position II erläuterten provisorischen Steckverbindung zur Platine 73 (Montageposition V). Der eine Steckfuß 72 rollt gegebenenfalls etwas aus, bringt aber im allgemeinen keine einem Grob-Crash vergleichbare Situation, so daß nun der Stößel 24 programmgesteuert abwärts fährt. Das auf der Platineoberseite verbliebene Steckfüßchen erlaubt es aber nicht, daß der Stößel 24 seine programmierte axiale Länge voll durchläuft. Über die entsprechende Stößelstellungs-Erkennungseinrichtung SE läßt sich nun die Funktion einleiten, daß der Greifer 52 das nicht ordnungsgemäß gesetzte Elektronikbauteil 71 wieder abzieht und in einen Ausschuß-Sammelschacht wirft. Weitere Funktionen können einprogrammiert sein dahingehend, daß er (52) sich ein neues Elektronikbauteil 71 faßt oder daß einfach der nächstfolgende Greifer 52 des Revolverkopfes die ordnungsgemäße Bestückung vornimmt.

Die Betätigung des Stößels 24 in der programmgemäß vorgesehenen Stoßlänge kann auch in eine Reaktion dahingehend übergehen, daß hierdurch der Revolverkopf relativ zum Roboterarm in Abweichung von der programmgemäßen Steuerung vorgeschoben wird (Freigang F), wodurch es zu einem Stillsezten der Vorrichtung bzw. zu einem erneuten Arbeitsversuch kommt.

**Ansprüche**

1.  Vorrichtung zur Kupplung eines Montagewerkzeuges, wie Greifer oder dergleichen, an dem Ende (1) eines Roboterarmes, mit einem Roboterarmende (1) steckverbundenen Revolverkopf-Träger (2) mit spitzwinklig (Winkel Alpha) zur Steckverbindungsachse (x-x) liegender, mit einem Einstellmotor (10) gekuppelter Revolverkopf-Drehachse (y-y) und einer Revolverkopf-Verriegelungseinrichtung (37) derart, daß jeweils eine von mehreren Montagewerkzeug-Aufnahmen (21) in koaxialer Stellung <Aufnahmeachsen (z-z)> zur Steckverbindung (x-x) liegt, wobei sich die Verlängerung der Steckverbindungsachse (x-x), die Verlängerung der Revolverkopf-Drehachse (y-y) und die sämtlicher Montagewerkzeug-Aufnahmeachsen (z-z) in einem Punkt (P) schneiden, gekennzeichnet durch mindestens zwei im Revolverkopf-Träger (2) vorgesehene, spitzwinklig und symmetrisch zur Einstecköffnungsachse (x-x) sowie revolverkopfseitig konvergierend verlaufende, durckmittelbetätigbare Stößel (24, 25), deren drehfugenseitige Aufnahmeöffnungen in jeder Drehstellung des Revolverkopfes (3) koaxial fluchtend liegen zu einem Einfahrraum (26) des Revolverkopfes (3), welcher Einfahrraum (26) in Verbindung steht mit den als Einstecköhlungen ausgebildeten Montagewerkzeug-Aufnahmen (21).

2.  Vorrichtung nach Anspruch 1, dadurch gekennzeichnet, daß der Schnittpunkt (P') der konvergierenden Stößel (24, 25) auf der Verlängerung der Einstecköffnungsachse (x-x) liegt.

3.  Vorrichtung nach einem oder mehreren der vorhergehenden Ansprüche, gekennzeichnet durch eine zentrale Druckmittelzufuhr im Bereich der Einstecköffnung (5).

4.  Vorrichtung nach einem oder mehreren der vorhergehenden Ansprüche, dadurch gkennzeichnet, daß im Bereich der Drehfuge zwischen Revolverkopf-Träger (2) und Revolverkopf (3) eine die Revolverkopf-Stellung abfragende Kodierscheibe (34) angeordnet ist.

5.  Vorrichtung nach Anspruch 4, dadurch gekennzeichnet, daß die Revolverkopf-Verriegelungseinrichtung (37) von einem druckmittelgesteuerten Riegelbolzen (38) gebildet ist, welcher, im Revolverkopf-Träger (2) sitzend, über die Drehfuge tretend, in die Kodierscheibe (34) eintritt.

6.  Vorrichtung nach einem oder mehreren der vorhergehenden Ansprüche, dadurch gekennzeichnet, daß der Revolverkopf (3) in Richtung der Einsteck-Öffnungsachse (x-x) unter Bildung eines Freiganges (F) längsverschieblich am Roboterarm (1) geführt ist.

7.  Vorrichtung nach Anspruch 6, dadurch gekennzeichnet, daß der Freigang (F) zwischen dem Revolverkopf-Träger (2) und dem Roboterarm (1) besteht und elektrisch abgefragt wird.

8.  Vorrichtung nach einem oder mehreren der vorhergehenden Ansprüche, dadurch gekennzeichnet, daß die Längsführung von einer revolverkopf-trägerseitigen Büchse (58) und einem darin koaxial geführten Schaft (60) gebildet ist.

9.  Vorrichtung nach Anspruch 8, dadurch gekennzeichnet, daß der Schaft (60) an seiner Mantelfläche mehrere Längsnuten (64) trägt, welche mit radial nach innen vorgespannten Rollgliedern (65) der Büchse (58) zusammenwirken.

10. Vorrichtung nach einem einer mehreren der vorhergehenden Ansprüche, gekennzeichnet durch eine Gewichtskompensations-Vorrichtung (V) für den Revolverkopf (3) sowie dessen Träger (2), welche Vorrichtung (V) von einer Kolben/Zylinder-Einheit (55/68) gebildet ist.

11. Vorrichtung nach Anspruch 10, dadurch gekennzeichnet, daß der Kolben (55) der Kolben/Zylinder-Einheit (55/68) mittels seiner in Einsteck-Öffnungsachsen-Richtung (x-x) verlaufenden Kolbenstange (57) an dem Roboterarm (1) befestigt ist und daß der Zylinder (68) am Revolverkopf-Träger (2) ausgebildet ist.

12. Vorrichtung nach einem oder mehreren der vorhergehenden Ansprüche 10, 11, dadurch gekennzeichnet, daß zur Zuleitung des Druckmittels für die Kolben/Zylinder-Einheit (55/68) die Kolbenstange (57) mit einem Axialkanal durchsetzt ist.

13. Vorrichtung nach Anspruch 6, dadurch gekennzeichnet, daß der Freigang-Hub von einer Erfassungseinrichtung (E) registriert und einer Steuervorrichtung des Roboterarmes zugeführt wird.

14. Vorrichtung nach Anspruch 13, dadurch gekennzeichnet, daß die Erfassungseinrichtung (E) als induktive oder kapazitive Wegabfragung ausgebildet und von einem im Wege des Kolbens (55) liegenden Initiator (56) gebildet ist.

15. Vorrichtung nach einem oder mehreren der vorhergehenden Ansprüche, dadurch gekennzeichnet, daß mindestens einer (24) der Stößel (24, 25) mit einer Stößelstellungs-Erkennungseinrichtung (SE) versehen ist.

16. Vorrichtung nach Anspruch 15, dadurch gekennzeichnet, daß die Stößelstellungs-Erkennungseinrichtung (SE) von einer Induktionsspule (70) gebildet ist, in der ein mit dem Stößel (24) verbundener Kern (69) längsverschieblich einliegt.

17. Vorrichtung nach einem oder mehreren der vorhergehenden Ansprüche, gekennzeichnet durch eine Rutschkupplung (18) vor der Stirnfläche (3') des Revolverkopfes (3).

## Claims

1. Device for coupling an assembly tool, such as a gripper or the like, to the end (1) of a robot arm, with a turret carrier (2) connected to the robot arm end (1) by a socket connection and having an axis of turret rotation (y-y) arranged at an acute angle (alpha) to the axis of the socket connection (x-x) and coupled to a servo motor (10), and with a turret locking device (37), such that at any given time one of several assembly tool holders (21) (holder axes z-z) lies in a position coaxial with the socket connection (x-x), wherein the extension of the socket connection axis (x-x), the extension of the axis of turret rotation (y-y) and that of all the assembly tool holder axes (z-z) intersect at a point (P), characterised by two or more pressurised fluid-operated rams (24, 25) which are provided in the turret carrier (2) and extend at an acute angle and symmetrically to the socket axis (x-x) as well as converging on the turret side and of which the receiving openings on the revolving joint side in each position of rotation of the turret (3) lie in coaxial alignment with an entry chamber (26) of the turret (3), which entry chamber (26) communicates with the assembly tool holders (21) constructed as socket cavities.

2. Device according to claim 1, characterised in that the point of intersection (P') of the converging rams (24, 25) is located on the extension of the socket axis (x-x).

3. Device according to one or more of the preceding claims, characterised by a central pressurised fluid supply in the region of the socket opening (5).

4. Device according to one or more of the preceding claims, characterised in that in the region of the revolving joint between turret carrier (2) and turret (3) is disposed a coding disc (34) which scans the turret position.

5. Device according to claim 4, characterised in that the turret locking device (37) is formed by a pressurised fluid-controlled locking bolt (38) which, seated in the turret carrier (2), passing across the revolving joint, enters the coding disc (34).

6. Device according to one or more of the preceding claims, characterised in that the turret (3) is guided on the robot arm (1) for longitudinal displacement in the direction of the socket axis (x-x), forming a free run (F).

7. Device according to claim 6, characterised in that the free run (F) exists between the turret carrier (2) and the robot arm (1) and is scanned electrically.

8. Device according to one or more of the preceding claims, characterised in that the longitudinal guide system is formed by a bush (58) on the turret carrier side and a shaft (60) guided coaxially therein.

9. Device according to claim 8, characterised in that the shaft (60) carries in its peripheral surface several longitudinal grooves (64) which cooperate with radially inwardly biassed rolling members (65) of the bush (58).

10. Device according to one or more of the preceding claims, characterised by a weight compensating device (V) for the turret (3) and its carrier (2), which device (V) is formed by a piston and cylinder unit (55/68).

11. Device according to claim 10, characterised in that the piston (55) of the piston and cylinder unit (55/68) is fixed to the robot arm (1) by means of its piston rod (57) extending in the direction of the socket axis (x-x) and that the cylinder (68) is constructed on the turret carrier (2).

12. Device according to one or more of the preceding claims 10, 11, characterised in that the piston rod (57) has an axial channel extending through it for supply of the pressurised fluid for the piston and cylinder unit (55/68).

13. Device according to claim 6, characterised in that the free run stroke is recorded by a detector (E) and delivered to a control device for the robot arm.

14. Device according to claim 13, characterised in that the detector (E) is constructed as an inductive or capacitive displacement scanner and formed by a proximity switch (56) located in the path of the piston (55).

15. Device according to one or more of the preceding claims, characterised in that at least one (24) of the rams (24, 25) is provided with a ram position detector (SE).

16. Device according to claim 15, characterised in that the ram position detector (SE) is formed by an induction coil (70) in which a core (69) connected to the ram (24) is located longitudinally displaceably.

17. Device according to one or more of the preceding claims, characterised by a sliding coupling (18) in front of the end face (3') of the turret (3).

**Revendications**

1. Dispositif d'accouplement d'un outil de montage tel qu'un organe de Préhension ou analogue à l'extrémité (1) d'un bras de robot, comprenant un support (2) de tête revolver emmanché dans l'extrémité (1) du bras de robot, suivant un angle aigu (angle alpha) par rapport à l'axe de la liaison d'emmanchement (x-x), un moteur de réglage (10) couplé à l'axe de rotation de la tête revolver (y-y) ainsi que d'une installation de verrouillage (37) de la tête revolver, pour que chaque fois l'un parmi plusieurs logements de réception (21) de l'outil de montage se trouve en position coaxiale (axe de réception z-z) par rapport à la liaison d'emmanchement (x-x), le prolongement de l'axe d'emmanchement (x-x), le prolongement de l'axe de rotation (y-y) de la tête revolver et celui de tous les axes des logements de réception d'outils de montage (z-z) se coupant en un point P, dispositif caractérisé par au moins deux poussoirs (24, 25) actionnés par un fluide sous pression, ces poussoirs faisant un angle aigu et symétrique par rapport à l'axe d'emmanchement (x-x) et convergeant du côté de la tête revolver, leurs orifices de réception du côté du joint de rotation, étant alignés coaxialement pour chaque position de rotation de la tête revolver (3) vers un volume de dégagement (26) de la tête revolver (3), ce volume (26) communiquant avec les logements (21) de l'outil de montage en forme de cavités d'emmanchement.

2. Dispositif selon la revendication 1, caractérisé en ce que le point d'intersection (P') des poussoirs convergents (24, 25) se situe sur le prolongement de l'axe d'emmanchement (x-x).

3. Dispositif selon l'une ou plusieurs des revendications précédentes, caractérisé par une alimentation centrale de fluide sous pression au niveau de l'orifice d'emmanchement (5).

4. Dispositif selon l'une ou plusieurs des revendications précédentes, caractérisé en ce qu'au niveau du joint de rotation entre le support (2) de la tête revolver et la tête revolver (3) il est prévu un disque de codage (34) qui permet de repérer la position de la tête revolver.

5. Dispositif selon la revendication 4, caractérisé en ce que l'installation de verrouillage de la tête revolver (37) est constituée par un goujon de verrouillage (38) commandé par un fluide sous pression, et qui, appuyé sur le support (2) de la tête revolver, pénètre dans le disque de codage (34) en traversant le joint de rotation.

6. Dispositif selon l'une ou plusieurs des revendications précédentes, caractérisé en ce que la tête revolver (3) est guidée dans la direction de l'axe de l'ouverture d'emmanchement (x-x) sur le bras (1) du robot, coulissement longitudinal, en ayant une course à vide (F).

7. Dispositif selon la revendication 6, caractérisé en ce que la course à vide (F) existe entre le support (2) de la tête revolver et le bras de robot (1) et cette course à vide est détectée électriquement.

8. Dispositif selon l'une ou plusieurs des revendications précédentes, caractérisé en ce que le guidage longitudinal est assuré par un manchon (58) situé du côté du support de la tête revolver et d'un axe (60) guidé coaxialement dans ce manchon.

9. Dispositif selon la revendication 8, caractérisé en ce que l'axe (60) comporte plusieurs rainures longitudinales (64) dans sa surface, et des organes de roulement (65) précontraints radialement vers l'intérieur du manchon (58) coopérant avec les rainures longitudinales.

10. Dispositif selon l'une ou plusieurs des revendications précédentes, caractérisé par un dispositif de compensation de poids (V) pour la tête revolver (3) ainsi que son support (2), ce dispositif (Y) étant formé par un ensemble piston/cylindre (55, 68).

11. Dispositif selon la revendication 10, caractérisé en ce que le piston (55) de l'ensemble piston/cylindre (55, 68) est fixé au bras (1) du robot par sa tige de piston (57) dirigée dans la direction de l'axe de l'ouverture d'emmanchement (x-x) et en ce que le cylindre (68) est réalisé sur le support (2) de la tête revolver.

12. Dispositif selon l'une ou plusieurs des revendications précédentes 10, 11, caractérisé en ce que l'alimentation en fluide sous pression de l'ensemble piston/cylindre (55, 68) est assurée par un canal axial réalisé dans la tige de piston (57).

13. Dispositif selon la revendication 6, caractérisé en ce que la course à vide est détectée par une installation de détection (E) et cette détection est transmise à un dispositif de commande du bras du robot.

14. Dispositif selon la revendication 13, caractérisé en ce que l'installation de détection (E) est un capteur de course à fonctionnement inductif ou capacitif et est formé par un initiateur (56) placé sur la trajectoire du piston (55).

15. Dispositif selon l'une ou plusieurs des revendications précédentes, caractérisé en ce qu'au moins l'un (24) des poussoirs (24, 25) est muni d'une installation de détection de la position du poussoir (SE).

16. Dispositif selon la revendication 15, caractérisé en ce que l'installation de détection de la position du poussoir (SE) est formée par une bobine d'induction (70) recevant de manière coulissante longitudinalement, un noyau (69) relié au poussoir (24).

17. Dispositif selon l'une ou plusieurs des revendications précédentes, caractérisé par un embrayage glissant (18) prévu sur la face frontale (3') de la tête revolver (3).

EP 0 233 648 B1

# FIG. 1

11

# FIG. 2

EP 0 233 648 B1

FIG. 3

# FIG. 4

FIG. 5

FIG. 6

Fig. 7

Fig. 8

Fig. 9